# FASCICULE DE BREVET EUROPEEN

(11) **EP 2 920 431 B1**
(45) Date de publication et mention de la délivrance du brevet: **03.04.2019**
(21) Numéro de dépôt: 13801644.9
(22) Date de dépôt: 12.11.2013
(51) Int. Cl.: F01D 21/02, F02C 9/28, F02C 9/32, H05K 7/14

(54) **CALCULATEUR DE TURBO-MACHINE D'AERONEF**
TURBOMASCHINENCOMPUTER FÜR FLUGZEUG
AIRCRAFT TURBOMACHINE COMPUTER

(30) Priorité: 13.11.2012 FR 1260800
(43) Date de publication de la demande: 23.09.2015
(73) Titulaire: Safran Power Units, 31200 Toulouse (FR)
(72) Inventeur: PASQUIER, Ludovic, 31150 Fenouillet (FR); AVEROUS, Daniel, 31380 Mont Joire (FR); JOACHIM, Rémi, 31280 Dremil-lafage (FR)
(74) Mandataire: Brevalex
(86) Numéro de dépôt international: PCT/FR2013/052701
(87) Numéro de publication internationale: WO 2014/076400

(56) Documents cités:
- EP-A2- 1 296 045
- EP-A2- 1 296 047
- FR-A1- 2 960 912
- FR-A1- 2 965 698

## Description

### DOMAINE TECHNIQUE

L'invention concerne un calculateur de turbo-machine, par exemple un groupe auxiliaire de puissance (APU), à bord d'un aéronef, par exemple un hélicoptère.

### ÉTAT DE LA TECHNIQUE ANTÉRIEURE

Le domaine de l'invention est celui des turbo-machines d'aéronef, et plus particulièrement celui des calculateurs de turbo-machines d'aéronefs utilisés pour réguler le comportement de ces turbo-machines.

Les documents EP 1 296 045 A2, FR 2 965 698 A1 et FR 2 960 912 A1 décrivent de tels calculateurs.

De tels calculateurs peuvent réunir dans un même boîtier un canal de régulation et un canal de surveillance ou de protection survitesse, ce qui permet d'obtenir un coût plus économique et une masse plus faible qu'une solution dans laquelle ces canaux seraient installés dans deux boîtiers séparés.

Le canal de régulation a pour fonction de réguler la vitesse de la turbo-machine. Mais une défaillance de ce canal de régulation peut entraîner une survitesse de l'arbre de turbine. En effet, lors d'une rupture de cet arbre, la puissance fournie par les gaz à la turbine n'est plus absorbée par les équipements entraînés par cet arbre et la vitesse de rotation de la turbine s'accroit de façon extrêmement rapide. Une telle survitesse aboutit très rapidement à une rupture des parties tournantes et/ou à leur séparation d'avec le disque de turbine. Ces parties tournantes sont alors projetées violemment vers l'extérieur du fait de la force centrifuge et peuvent traverser le carter entourant la turbine, provoquant des dégâts très importants dans le moteur, et pouvant même mettre en danger l'aéronef et ses passagers.

Le canal de protection survitesse à pour objet de prévenir les conséquences d'une telle survitesse. Le canal de protection survitesse comporte un organe électronique associé à un organe hydromécanique. L'organe électronique mesure la vitesse de rotation du rotor. Si l'organe électronique détecte une survitesse, il commande alors l'organe hydromécanique, qui coupe le carburant d'alimentation de la turbo-machine.

L'invention a pour objet de proposer une solution à un problème technique difficile à résoudre qui est celui d'une défaillance de mode commun, c'est-à-dire à la fois une défaillance du canal de régulation et une défaillance du canal de protection survitesse, en particulier celles dues à une origine externe au calculateur (événements dits « local events »)

### EXPOSÉ DE L'INVENTION

L'invention concerne un calculateur de turbo-machine d'aéronef, comprenant un boîtier métallique parallélépipédique contenant un circuit électronique dans lequel sont intégrés un canal de commande et un canal de surveillance, caractérisé en ce que le boîtier comprend une première cavité dans laquelle est disposée une première carte électronique de gestion du canal de commande et une seconde cavité indépendante de la première cavité, dans laquelle est disposée une seconde carte électronique de gestion du canal de surveillance, ces cartes électroniques étant disposées dans deux plans orientés l'un par rapport à l'autre selon un angle de 90°.

Avantageusement chaque carte est reliée à au moins un connecteur situé sur une face du boîtier. Chaque connecteur peut être un connecteur multibroche.

Avantageusement le calculateur de l'invention comprend une troisième carte électronique disposée dans la première cavité, cette troisième carte électronique étant reliée électriquement à la première carte électronique.

Avantageusement la première et la seconde cartes électriques sont isolées galvaniquement l'une par rapport à l'autre. La première et la seconde cartes électroniques peuvent ainsi être reliées entre elles par une liaison optique.

Avantageusement le boîtier est réalisé en aluminium ou en titane. Il peut avoir une largeur comprise entre 10 et 40 cm, typiquement 30 cm, une hauteur comprise entre 10 et 30 cm, typiquement 10 cm et une épaisseur comprise entre 3 et 10 cm, typiquement 5 cm.

Le calculateur de l'invention peut être un calculateur d'un groupe auxiliaire de puissance (APU). L'invention peut concerner un aéronef, par exemple un hélicoptère, mettant en oeuvre un tel calculateur.

### BRÈVE DESCRIPTION DES DESSINS

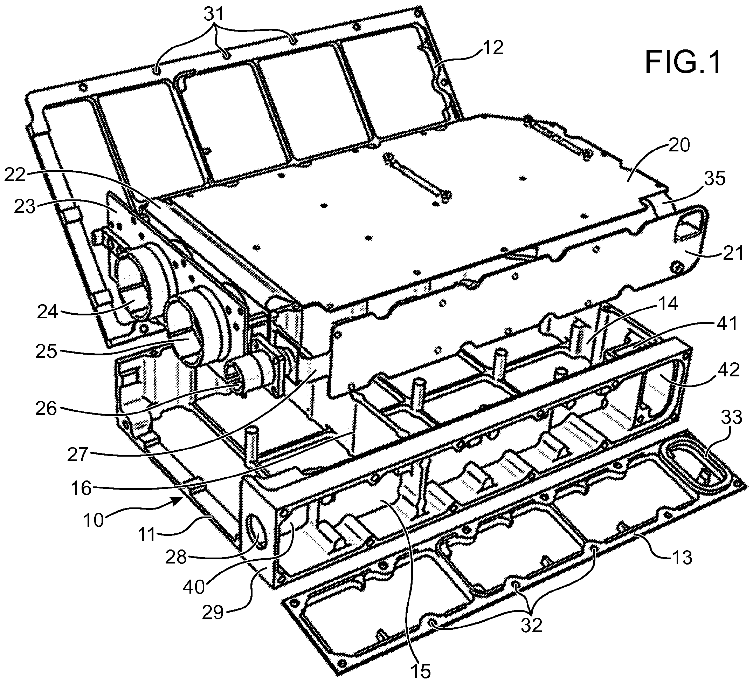

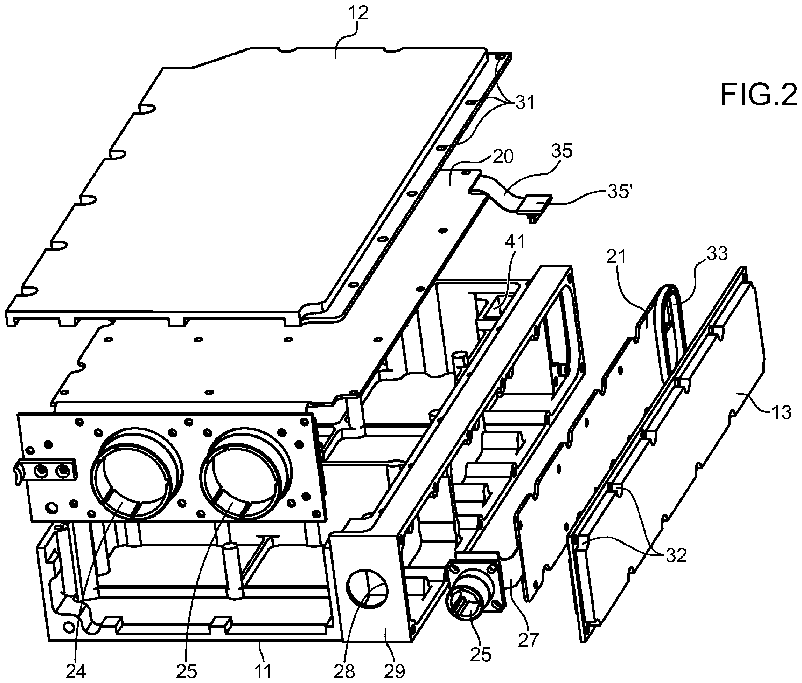

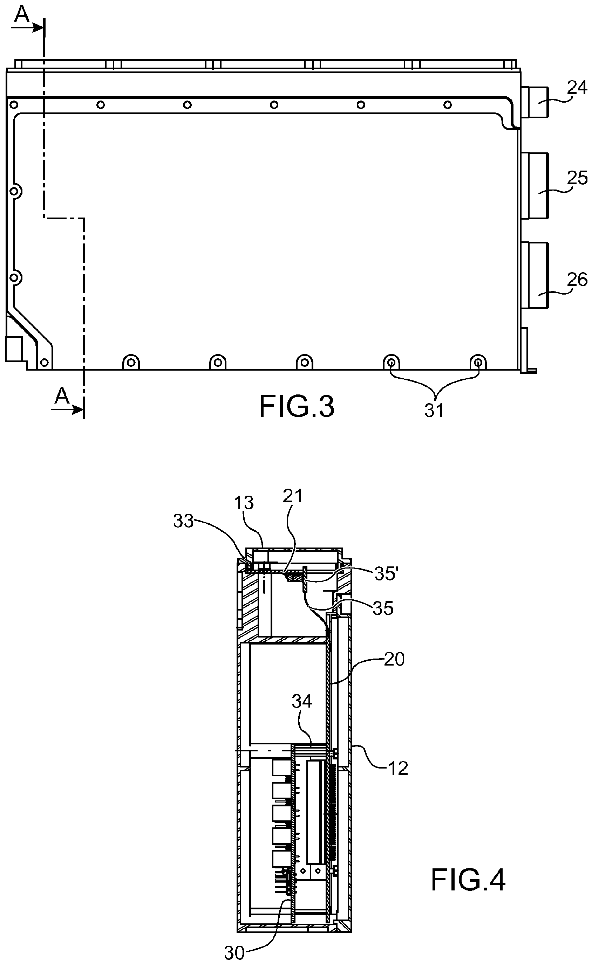

Les figures 1 à 4 illustrent le calculateur de turbo-machine d'aéronef selon l'invention ; les figures 1 et 2 étant des vues en éclaté isométriques, la figure 3 étant une vue de face et la figure 4 une vue en coupe A-A, la ligne brisée A-A étant représentée sur la figure 3.

### EXPOSÉ DÉTAILLÉ DE MODES DE RÉALISATION PARTICULIERS

Le calculateur de turbo-machine d'aéronef de l'invention comprend un boîtier métallique parallélépipédique 10 contenant une première et une seconde cavités parallélépipédiques 14 et 15 indépendantes dans lesquelles sont disposées respectivement une première et une seconde cartes électroniques 20 et 21 dans lesquelles sont respectivement intégrées un canal de commande et un canal de surveillance. Ces cartes sont disposées dans deux plans orientés l'un par rapport à l'autre pour un former un angle déterminé, par exemple 90°.

Comme illustré sur les figure 1 à 4, le boîtier 10 est constitué d'un bâti 11 parallélépipédique et de deux couvercles 12 et 13 qui viennent respectivement se fixer sur la face supérieure et sur une face latérale du bâti 11 pour former deux cavités indépendantes 14 et 15 de forme parallélépipédique. Les couvercles 12 et 13 peuvent être fixés par vissage sur le bâti 11, au travers de trous 31 et 32, des joints 33 pouvant être disposés dans les espaces intercalaires.

La première cavité 14 séparée en deux par une paroi 16 est conçue pour recevoir la première carte électronique 20 de gestion du canal de commande. La seconde cavité 15 est conçue pour recevoir la seconde carte électronique 21 de gestion du canal de surveillance.

La première cavité 14 peut contenir également une troisième carte électronique 30, disposée dans le fond de la première cavité 14 comme illustré sur la figure 4, pouvant être reliée électriquement à la première carte 20 par des connecteurs à broche. Une telle troisième carte électronique 30 a donc pour objet de compléter fonctionnellement la première carte électronique.

La première carte électronique 20 est reliée par un conducteur souple 22 à une petite carte 23, sur laquelle sont fixées deux connecteurs multibroches 24 et 25, et qui vient s'encastrer sur la partie avant du bâti 11. La seconde carte électronique 21 est reliée à un connecteur multibroches 26 par un conducteur souple 27. Ce connecteur 26 vient se fixer dans une ouverture 28 pratiquée sur la partie avant du bâti 11.

Comme représenté sur la figure 4, des entretoises 34 permettent d'espacer la première carte électronique 20 et la troisième carte électronique 30.

La première carte électronique est reliée à la seconde carte électrique par un conducteur souple 35 terminée par un connecteur 35' assurant une liaison galvanique, ce conducteur étant destiné à traverser l'ouverture 42 réalisée dans le bâti 11. Les cloisons 40 et 41 entre la première cavité 14 et la seconde cavité assurent leur indépendance.

Le calculateur de l'invention est ainsi composé de deux cartes électroniques 20 (éventuellement complétée par la troisième carte 30) et 21 installées dans deux volumes indépendants, orientées selon un angle déterminé l'une par rapport à l'autre, avantageusement selon un angle de 90° garantissant une absence de mode commun de défaillance de nature vibratoire. Ces deux volumes garantissent une absence de mode commun de défaillance de nature physique, thermodynamique, chimique, électrique...

Une telle solution facilite l'installation de connecteurs indépendants pour chaque carte. Elle facilite également l'utilisation de deux alimentations indépendantes.

Dans un mode de réalisation avantageuse, le calculateur a les dimensions représentées en figures 3 et 4 (figures à l'échelle 1:1).

Les deux cartes électroniques 20 et 21 sont reliées entre elles par une interface minimalisée assurée par exemple par des opto-coupleurs garantissant l'indépendance électrique des deux canaux de commande et de sécurité.

Le calculateur de l'invention permet d'éliminer toutes les causes communes de pannes, en autorisant une grande flexibilité :
- La fabrication en externe d'une des cartes électroniques 20 (30) et 21 permet de résoudre les causes communes de fabrication.
- L'étanchéité entre les deux cavités 14 et 15 permet de résoudre les causes communes thermodynamiques d'échauffement mutuel ou d'exposition à une sur-température simultanée des cartes électroniques 20 (30) et 21.
- L'étanchéité entre les deux cavités 14 et 15 permet de résoudre les causes communes physicochimiques ou d'exposition à un risque mécanique. Le risque de ruissellement sur les cartes électroniques 20 (30) et 21 est résolu. Le risque d'utilisation d'une vis qui provoque un court circuit simultané est résolu.
- L'indépendance des cavités 14 et 15 permet une bonne isolation électrique des cartes électroniques 20 (30) et 21 en évitant les pannes électriques en cascade d'une carte à l'autre, celles-ci pouvant être liées au foudroiement, aux variations de fourniture électrique par le réseau de bord.
- La disposition perpendiculaire des cartes électroniques 20 (30) et 21 résout les résonnances mécaniques en modifiant l'exposition à la vibration et garantit une rupture non simultanée de ces cartes.
- Un problème électrique existant sur une carte électronique 20 (30) ne se propage pas électriquement à l'autre carte 21.
- Une panne de la liaison entre les cartes électroniques a pour seul impact de mettre le calculateur en sécurité : le canal surveillance arrête le calculateur ou empêche celui-ci de démarrer.

## Revendications

1. Calculateur de turbo-machine d'aéronef comprenant un boîtier métallique parallélépipédique (10) contenant un circuit électronique dans lequel sont intégrés un canal de commande et un canal de surveillance, le boîtier (10) comprenant une première cavité (14) dans laquelle est disposée une première carte électronique (20) de gestion du canal de commande et une seconde cavité, indépendante de la première cavité, dans laquelle est disposée une seconde carte électronique (21) de gestion du canal de surveillance, le calculateur étant **caractérisé en ce que** ces cartes électroniques sont disposées dans deux plans orientés l'un par rapport à l'autre selon un angle de 90°.

2. Calculateur selon la revendication 1, dans lequel chaque carte électronique (20, 21) est reliée à au moins un connecteur (24, 25, 26) situé sur une face du boîtier.

3. Calculateur selon la revendication 2, dans lequel chaque connecteur est un connecteur multibroches.

4. Calculateur selon la revendication 1, qui comprend une troisième carte électronique (30) disposée dans la première cavité (14), cette troisième carte étant reliée électriquement à la première carte électronique (20).

5. Calculateur selon la revendication 1, dans lequel la première et la seconde cartes électroniques (20, 21) sont isolées galvaniquement l'une par rapport à l'autre.

6. Calculateur selon la revendication 5, dans lequel la première et la seconde cartes électroniques (20, 21) sont reliées entre elles par une liaison optique.

7. Calculateur selon la revendication 1, dans lequel le boîtier (10) est réalisé en aluminium ou en titane.

8. Calculateur selon la revendication 1, dans lequel le boîtier (10) a une largeur comprise entre 10 et 40 cm, une hauteur comprise entre 10 et 30 cm et une épaisseur comprise entre 3 et 10 cm.

9. Aéronef mettant en oeuvre un calculateur selon l'une quelconque des revendications précédentes.

## Patentansprüche

1. Turbotriebwerksrechner für Luftfahrzeuge, der ein quaderförmiges Metallgehäuse (10) aufweist, das einen elektronischen Schaltkreis enthält, in den ein Steuerkanal und ein Kontrollkanal integriert sind, wobei das Gehäuse (10) einen ersten Hohlraum (14) enthält, in dem eine erste Elektronikkarte (20) zur Steuerung des Steuerkanals angeordnet ist, und einen von dem ersten Hohlraum getrennten zweiten Hohlraum enthält, in dem eine zweite Elektronikkarte (21) zur Steuerung des Kontrollkanals angeordnet ist,
**dadurch gekennzeichnet,**
**dass** diese Elektronikkarten in zwei Ebenen angeordnet sind, die in einem 90°-Winkel zueinander ausgerichtet sind.

2. Rechner nach Anspruch 1, bei dem jede Elektronikkarte (20, 21) mit mindestens einem Steckverbinder (24, 25, 26) verbunden ist, der sich an einer Seite des Gehäuses befindet.

3. Rechner nach Anspruch 2, bei dem jeder Steckverbinder ein Mehrfachsteckverbinder ist.

4. Rechner nach Anspruch 1, der eine dritte Elektronikkarte (30) enthält, die in dem ersten Hohlraum (14) angeordnet ist, wobei diese dritte Karte elektrisch mit der ersten Elektronikkarte (20) verbunden ist.

5. Rechner nach Anspruch 1, bei dem die erste und die zweite Elektronikkarte (20, 21) galvanisch gegeneinander isoliert sind.

6. Rechner nach Anspruch 5, bei dem die erste und die zweite Elektronikkarte (20, 21) durch eine optische Verbindung miteinander verbunden sind.

7. Rechner nach Anspruch 1, bei dem das Gehäuse (10) aus Aluminium oder aus Titan ausgeführt ist.

8. Rechner nach Anspruch 1, bei dem das Gehäuse (10) eine Breite von 10 bis 40 cm, eine Höhe von 10 bis 30 cm und eine Tiefe von 3 bis 10 cm hat.

9. Luftfahrzeug, in dem ein Rechner nach einem der vorigen Ansprüche zum Einsatz kommt.

## Claims

1. An aircraft turbomachine calculator comprising a parallelepiped metal casing (10) containing an electronic circuit wherein a control channel and a monitoring channel are integrated, the casing (10) comprising a first cavity (14) wherein a first electronic board (20) for managing the control channel is arranged, and a second cavity, independent of the first cavity, wherein a second electronic board (21) for managing the monitoring channel is arranged, the calculator being **characterized in that** these electronic boards are provided in two planes oriented with respect to each other at an angle of 90°.

2. The calculator according to claim 1, wherein each electronic board (20, 21) is connected to at least one connector (24, 25, 26) located on a face of the casing.

3. The calculator according to claim 2, wherein each connector is a multipin connector.

4. The calculator according to claim 1, which comprises a third electronic board (30) provided in the first cavity (14), this third board being electrically connected to the first electronic board (20).

5. The calculator according to claim 1, wherein the first and second electronic boards (20, 21) are galvanically isolated from each other.

6. The calculator according to claim 5, wherein the first and second electronic boards (20, 21) are connected to each other by an optical link.

7. The calculator according to claim 1, wherein the casing (10) is made of aluminum or titanium.

8. The calculator according to claim 1, wherein the casing (10) has a width between 10 and 40 cm, a height between 10 and 30 cm and a thickness between 3 and 10 cm.

9. An aircraft implementing a calculator according to any of the preceding claims.
